# EUROPEAN PATENT SPECIFICATION

(11) **EP 1 339 111 B1**
(45) Date of publication and mention of the grant of the patent: **09.05.2007**
(21) Application number: 02425089.6
(22) Date of filing: 20.02.2002
(51) Int. Cl.: H01L 45/00, H01L 27/24

(54) **Contact structure, phase change memory cell, and manufacturing method thereof with elimination of double contacts**
Kontaktstruktur, Phasenwechsel-Speicherzelle und deren Herstellungsverfahren mit Elimination von Doppelkontakten
Structure de contact, cellule mémoire à changement de phase et sa méthode de fabrication avec élimination des doubles contacts

(43) Date of publication of application: 27.08.2003
(73) Proprietor: STMicroelectronics S.r.l., 20041 Agrate Brianza (Milano) (IT); Ovonyx Inc., Rochester Hills, MI 48309 (US)
(72) Inventor: Pellizzer, Fabio, 31051 Follina (IT)
(74) Representative: Cerbaro, Elena

(56) References cited:
- WO-A-02/09206
- US-A- 6 031 287
- US-A1- 2002 017 701

## Description

The present invention relates to a contact structure, a phase change memory cell, and a manufacturing process thereof.
As is known, phase change memory (PCM) elements exploit the characteristics of materials which have the property of changing between two phases having distinct electrical characteristics. For example, these materials may change from an amorphous phase, which is disorderly, to a crystalline or polycrystalline phase, which is orderly, and the two phases are associated to considerably different resistivity.

At present, alloys of group VI of the periodic table, such as Te or Se, referred to as chalcogenides or chalcogenic materials, can advantageously be used in phase change cells. The chalcogenide that currently offers the most promise is formed by a Ge, Sb and Te alloy (Ge₂Sb₂Te₅), which is currently widely used for storing information in overwritable disks.

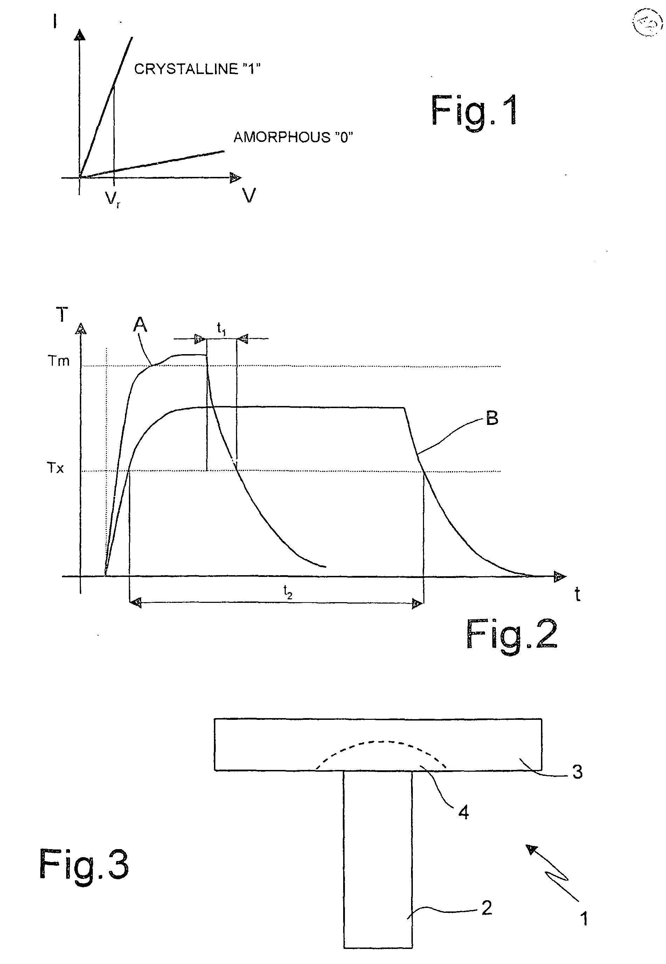

In chalcogenides, the resistivity varies by two or more magnitude orders when the material passes from the amorphous phase (more resistive) to the polycrystalline phase (more conductive) and vice versa. The characteristics of chalcogenides in the two phases are shown in Figure 1. As may be noted, at a given read voltage, here designated by Vr, there is a resistance variation of more than 10.

Phase change may be obtained by locally increasing the temperature, as shown in Figure 2. Below 150°C both phases are stable. Above 200°C (temperature of start of nucleation, designated by Tₓ) , fast nucleation of the crystallites takes place, and, if the material is kept at the crystallization temperature for a sufficient length of time (time t₂), it changes its phase and becomes crystalline. To bring the chalcogenide back into the amorphous state, it is necessary to raise the temperature above the melting temperature Tₘ (approximately 600°C) and then to cool the chalcogenide off rapidly (time t₁).

From the electrical standpoint, it is possible to reach both critical temperatures, namely the crystallization temperature and the melting point, by causing a current to flow through a resistive element which heats the chalcogenic material by the Joule effect.

The basic structure of a PCM element 1 which operates according to the principles described above is shown in Figure 3 and comprises a resistive element 2 (heater) and a programmable element 3. The programmable element 3 is made of a chalcogenide and is normally in the polycrystalline state in order to enable a good flow of current. One part of the programmable element 3 is in direct contact with the resistive element 2 and forms the area affected by phase change, hereinafter referred to as the phase change portion 4.

If an electric current having an appropriate value is caused to pass through the resistive element 2, it is possible to heat the phase change portion 4 selectively up to the crystallization temperature or to the melting temperature and to cause phase change. In particular, if a current I flows through a resistive element 2 having resistance R, the heat generated is equal to I²R.

The use of the PCM element of Figure 3 for forming memory cells has already been proposed. In order to prevent noise caused by adjacent memory cells, the PCM element is generally associated to a selection element, such a MOS transistor, a bipolar transistor, or a diode.

All the known approaches are, however, disadvantageous due to the difficulty in finding solutions that meet present requirements as regards capacity for withstanding the operating currents and voltages, as well as functionality and compatibility with present CMOS technologies.

In particular, considerations of a technological and electrical nature impose the creation of a contact area of small dimensions, preferably 20 nm x 20 nm, between the chalcogenic region and a resistive element. However, these dimensions are much smaller than those that can be obtained with current optical (UV) lithographic techniques, which scarcely reach 100 linear nm.

To solve the above problem, patent application 01128461.9 (publication number 1 318 552 A1), filed on 5.12.2001, and entitled "Small area contact region, high efficiency phase change memory cell, and manufacturing method thereof", teaches forming the contact area as an intersection of two thin portions extending transversely with respect to one another and each of a sublithographic size. In order to form the thin portions, deposition of layers is adopted instead of a lithographic process, given that deposition makes it possible to obtain very thin layers, i.e., having a thickness much smaller than the current minimum size that can be achieved using lithographic techniques.

For a better understanding of the problem of the present invention, the manufacturing process object of the above mentioned patent application No. 01128461.9 will now be described.

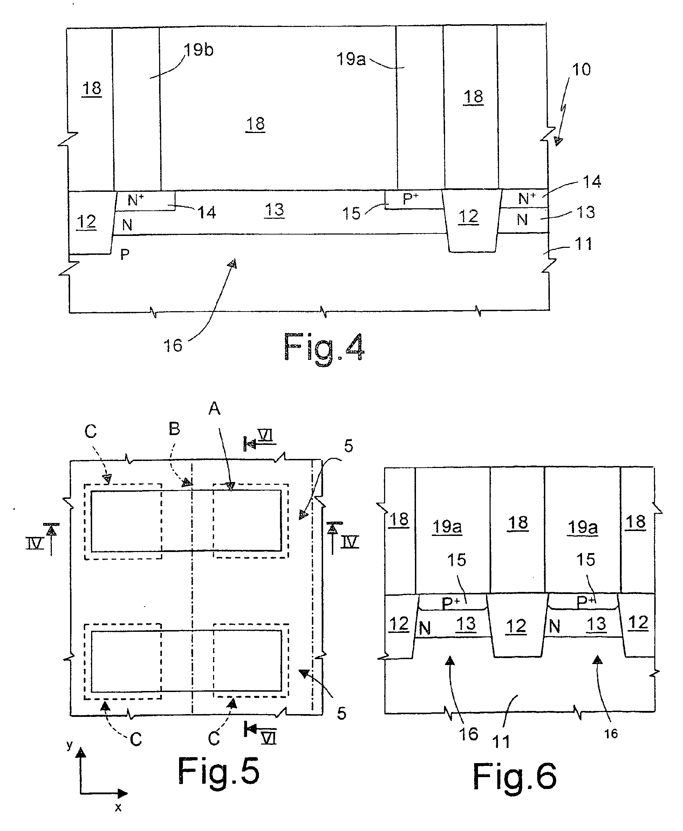

With reference to Figure 4, initially a wafer 10 comprising a P-type substrate 11 is subjected to standard front end steps. In particular, inside the substrate 11 insulation regions 12 are formed and delimit active areas 16; then, in succession, N-type base regions 13, N⁺-type base contact regions 14, and P⁺-type emitter regions 15 are implanted. The base regions 13, base contact regions 14, and emitter regions 15 form diodes that form selection elements for the memory cells.

Next, a first dielectric layer 18 is deposited and planarized; openings are formed in the first dielectric layer 18 above the base contact regions 13 and emitter regions 15, and the openings are filled with tungsten to form base contacts 19b and emitter contacts 19a. The base contacts 19b are thus in direct electrical contact with the base contact regions 13, and the emitter contacts 19a are in direct electrical contact with the emitter regions 15. Advantageously, the openings in the first dielectric layer 18 can be covered by a barrier layer, for example a Ti/TiN layer, before being filled with tungsten. In this way, the structure of Figure 4 is obtained.

Figure 5 shows the layout of some masks used for forming the structure of Figure 4 regarding a pair of memory cells 5 that are adjacent in a perpendicular direction to the sectional plane of Figure 4 (Y direction) . In particular, the figure shows a mask A used for defining the active areas 16, a mask B used for implanting the emitter regions 15, and a mask C for forming the openings where the base contacts 19b and the emitter contacts 19a are to be formed. Figure 4 is a cross-section taken along line IV-IV of Figure 5, while Figure 6 shows the same structure sectioned along the section line VI-VI of Figure 5.

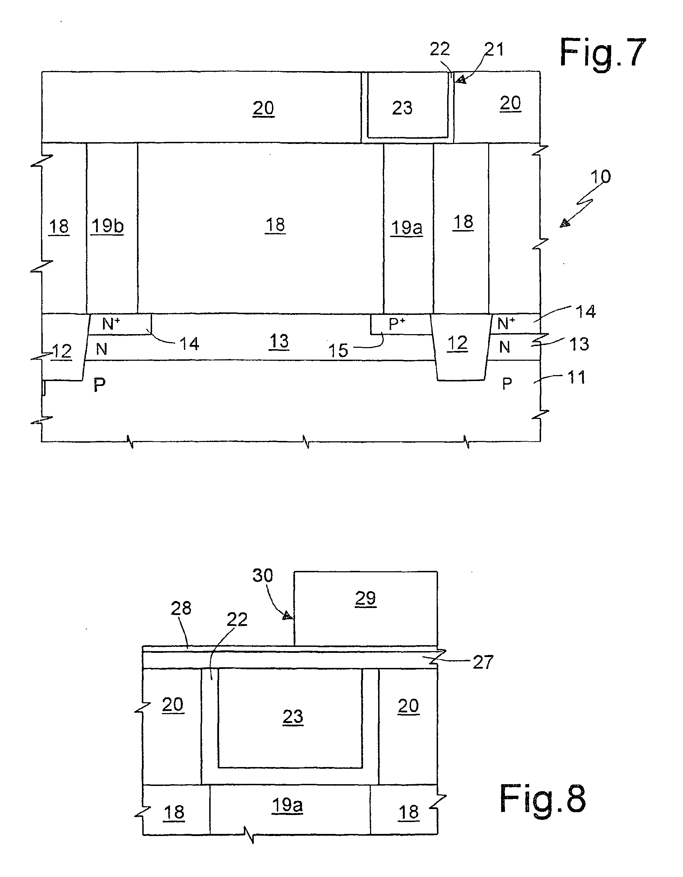

Next (Figure 7), a second dielectric layer 20 -for example, an undoped silicon glass (USG) layer- is deposited, and openings 21 are formed in the second dielectric layer 20 above the emitter contact 19a. The openings 21 have dimensions dictated by the lithographic process and are, for example, circle-shaped. Next, a heating layer, for example of TiSiN, TiAlN or TiSiC, is deposited for a thickness of 10-50 nm, preferably 20 nm. The heating layer, designed to form the resistive element 2 of Figure 3, conformally coats the walls and bottom of the openings 21 and is subsequently removed outside the openings 21. The remaining portions of the heating layer thus form a cup-shaped region 22 and are then filled with dielectric material 23.

Next, as shown in the enlarged detail of Figure 8, a mold layer 27, for instance USG having a thickness of 20 nm, an adhesion layer 28, for instance Ti or Si with a thickness of 5 nm, and a first delimiting layer 29, for example nitride or another material that enables selective etching with respect to the adhesion layer 28, are deposited in sequence. The first delimiting layer 29 has a thickness of, for instance, 150 nm. Then, using a mask, one part of the first delimiting layer 29 is removed by dry etching to form a step which has a vertical side 30 that extends vertically on top of the dielectric material 23. The structure shown in Figure 8 is thus obtained.

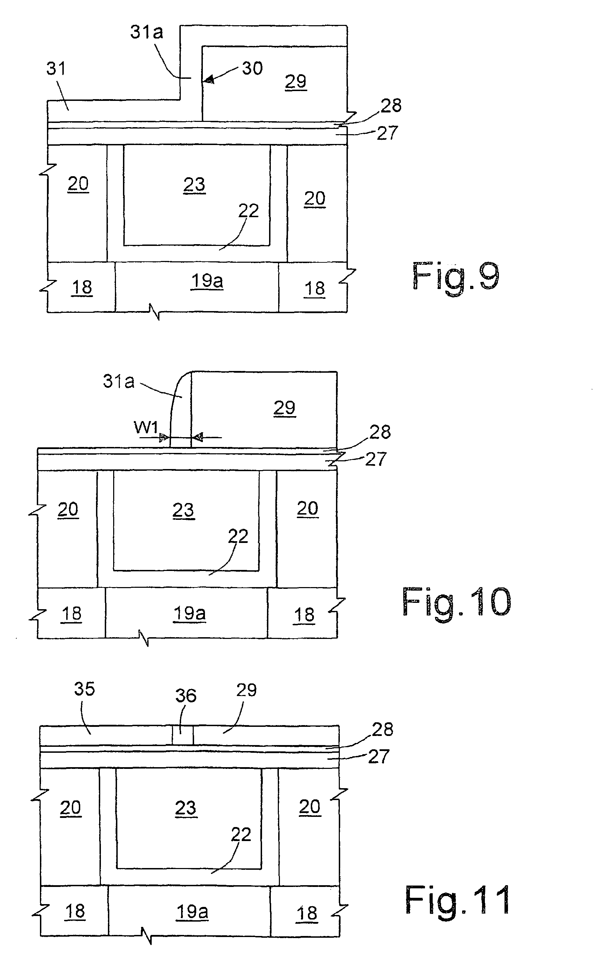

Next (Figure 9), a sacrificial layer 31, for example TiN with a thickness of 30 nm, is deposited conformally. In particular, the sacrificial layer forms a vertical wall 31a that extends along the vertical side 30 of the first delimiting layer 29.

Next (Figure 10), the sacrificial layer 31 undergoes an etch back that results in removal of the horizontal portions of the sacrificial layer 31 and of part of the vertical wall 31a. By appropriately choosing the thickness of the first delimiting layer 29 and the thickness of the sacrificial layer 31, as well as the time and type of etching, it is possible to obtain the desired sublithographic width W1 for the bottom part of the remaining vertical wall 31a.

As shown in Figure 11, a second delimiting layer 35, of the same material as the first delimiting layer 29, for example nitride, with a thickness of 300 nm, is deposited. Next, the delimiting layers 29, 35 and the vertical wall 31a are thinned by Chemical Mechanical Polishing (CMP). At the end, the remaining portions of the delimiting layers 29, 35 form a hard mask, and the remaining portion of the vertical wall forms a sacrificial region 36.

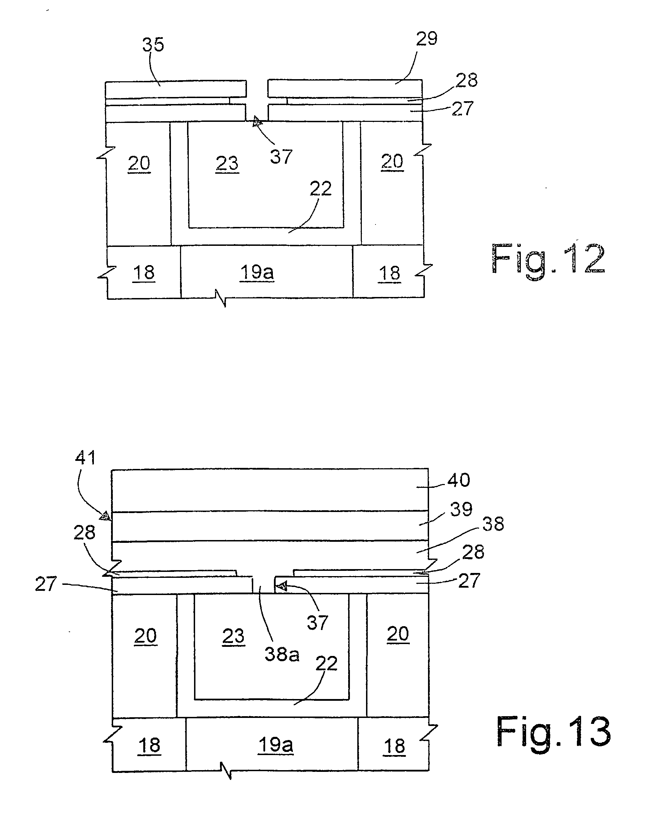

Next (Figure 12), the sacrificial region 36 is removed. The adhesion layer 28 is isotropically etched, and the mold layer 27 is dry etched to form a slit 37 in the mold layer 27, the slit 37 having a width W1 equal to the width of the sacrificial region 36.

Next (Figure 13), the delimiting layers 29, 35 are removed, and a chalcogenic layer 38, for example of Ge₂Sb₂Te₅ with a thickness of 60 nm, is deposited conformally. The portion 38a of the chalcogenic layer 38 fills the slit 37 and forms, at the intersection with the cup-shaped region 22, a phase change region similar to the phase change portion 4 of Figure 3. Then, on top of the chalcogenic layer 38 a barrier layer 39, for example of Ti/TiN, and a metal layer 40, for example of AlCu, are deposited. The structure of Figure 13 is thus obtained.

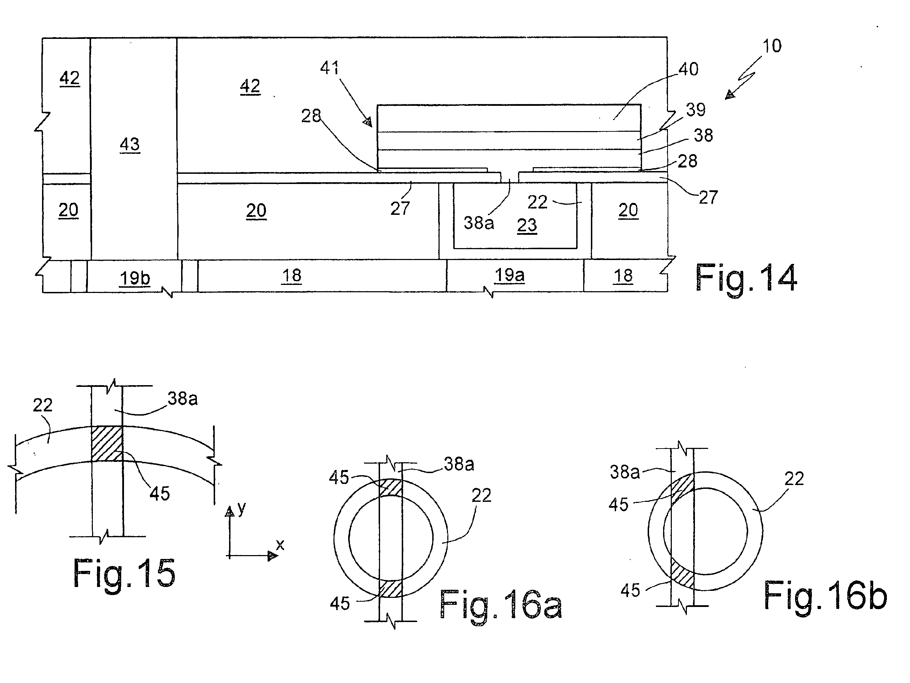

Next (Figure 14), the stack formed by the metal layer 40, barrier layer 39, chalcogenic layer 38, and adhesion layer 28 is defined using a same mask to form a bit line 41. Finally, a third dielectric layer 42 is deposited, which is opened above the base contacts 19b. The openings thus formed are filled with tungsten to form top contacts 43 in order to prolong upwards the base contacts 19b. Then standard steps are performed for forming the connection lines for connection to the base contacts 19b and to the bits lines 41, and the final structure of Figure 14 is thus obtained.

In practice, as shown in Figure 15, the intersection between the cup-shaped region 22 and the thin portion 38a of the chalcogenic layer 38 forms a contact area 45 which is approximately square and has sublithographic dimensions. This is due to the fact that both the cup-shaped region 22 and the thin portion 38a have a width equal to the thickness of a deposited layer. In fact, the width of the cup-shaped region 22 is given by the thickness of the heating layer, and the width of the thin portions 38a is determined by the thickness of the sacrificial layer 31 along the vertical side 30. In greater detail, in the proximity of the contact area 45, the cup-shaped region 22 has a sublithographic dimension in a first direction (Y direction), and the thin portion 38a has a sublithographic dimension (width W1 of Figure 10) in a second direction (X direction) which is transverse to the first direction. Hereinafter, the term "sublithographic dimension" means a linear dimension smaller than the limit dimension achievable with current optical (UV) lithographic techniques, and hence smaller than 100 nm, preferably 50-60 nm, down to approximately 20 nm.

In the process described above, forming the thin portion 38a of the chalcogenic layer 38 entails numerous steps and is somewhat complex. Consequently, it is desirable to avail a simpler alternative process.

In addition, the dimensions of the contact area 45 depend upon the alignment tolerances between the mask used for forming the openings 21 and the mask used for removing part of the first delimiting layer 29 and for forming the vertical side 30 (Figure 8). In fact, as emerges clearly from a comparison between Figures 16a and 16b which are top plan views of the contact area 45, in the case of a cup-like region 22 having a circular shape and a diameter of approximately 0.2 µm, an alignment error of even only 0.05 µm between the two masks results in the thin portions 38a no longer crossing the cup-shaped regions 22 perpendicularly, with a consequent considerable increase in the dimensions of the contact area 45 (see Figure 16b) and hence a considerable increase in the flowing current, the value whereof would be uncontrollable.

Furthermore, the thin portion 38a crosses each cup-shaped region 22 in two points, thus doubling the total contact area between the thin portions 38a and the cup-shaped regions 22, and consequently also increasing the programming current. In the case of a marked misalignment between the two above masks, just one contact area is even obtained which has dimensions far greater than the requirements. The presence of a double contact gives rise to functional problems, given that in this situation it would be impossible to know which of the two contact areas 45 first causes switching of the overlying thin portion 38a (i.e., the phase change portion), nor would it be possible to be certain that both of the thin portions 38a overlying the two contact areas will switch.

The aim of the present invention is to simplify and improve the process described in patent application 01128461.9, with particular regard to the problem of the total contact area between the cup-shaped region 22 and the thin portion 38a.

According to the present invention there are provided a contact structure, a phase change memory cell, and a manufacture process thereof, as defined in claims 1, 2, 10, and 11, respectively. Claims 8 and 21 define a memory array and a process for forming a pair of adjacent memory cells.

For a better understanding of the present invention, a preferred embodiment thereof is now described, purely by way of non-limiting example, with reference to the attached drawings, wherein:
- Figure 1 shows the current versus voltage characteristic of a phase change material;
- Figure 2 shows the temperature versus current plot of a phase change material;
- Figure 3 shows the basic structure of a PCM memory element;
- Figure 4 shows a cross section of a wafer of semiconductor material in a manufacturing step of the cell of Figure 3, according to the aforementioned patent application;
- Figure 5 shows the layout of some masks used for forming the structure of Figure 4;
- Figure 6 is a cross-section taken along line VI-VI of Figure 5;
- Figures 7-14 are cross-section of the structure of the above mentioned patent application, in successive manufacture steps;
- Figure 15 is a top plan view, with parts removed and at an enlarged scale, of a detail of Figure 4;
- Figures 16a and 16b are top plan views, with parts removed, of a detail of Figure 14, in two different manufacture conditions;
- Figure 17 shows the layout of some masks used for forming the structure of Figure 7, according to a first embodiment of the invention;
- Figure 18 is a cross-section of the structure, analogous to Figure 8, in a fabrication step according to the first embodiment;
- Figure 19 shows the layout of some masks used for forming the structure of Figure 18;
- Figures 20 and 21 are cross-sections, similar to Figure 18, in successive manufacture steps according to the invention;
- Figure 22 is a top plan view of the structure of Figure 21;
- Figure 23 is a cross-section, similar to Figure 21, in a subsequent manufacture step;
- Figure 24 shows the layout of same masks used for forming the structure of Figure 23;
- Figure 25 is a cross-section, similar to Figure 14, in a final manufacture step according to the invention;
- Figures 26a and 26b are top plan views of the contact area, in two different manufacture conditions; and
- Figure 27 shows the layout of some masks used after forming the structure of Figure 10, according to a different embodiment of the invention; and
- Figure 28 is a top plan view of the structure obtained with the masks of Figure 27.

In the following description, parts that are the same as those previously described with reference to Figures 4-14 are designated by the same reference numbers.

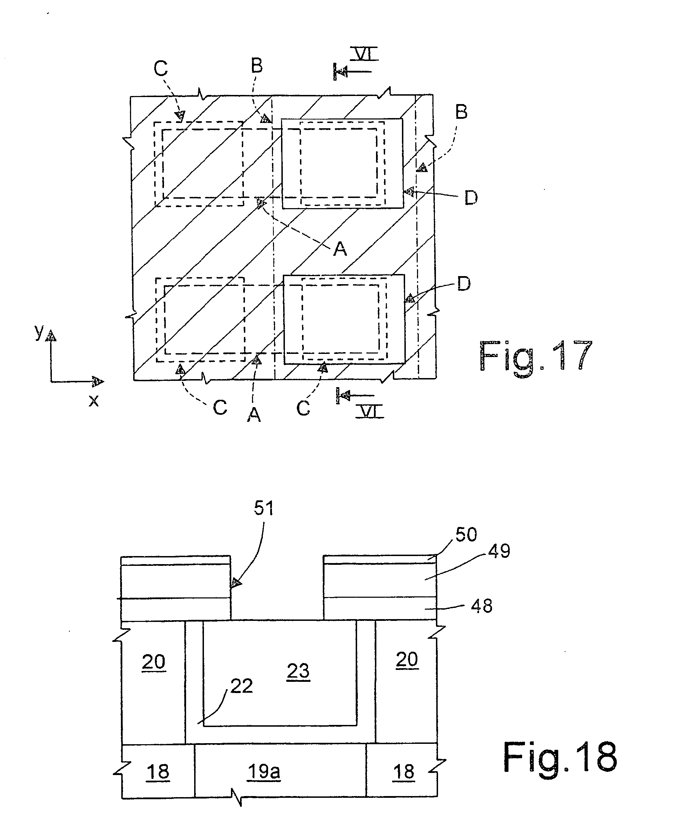

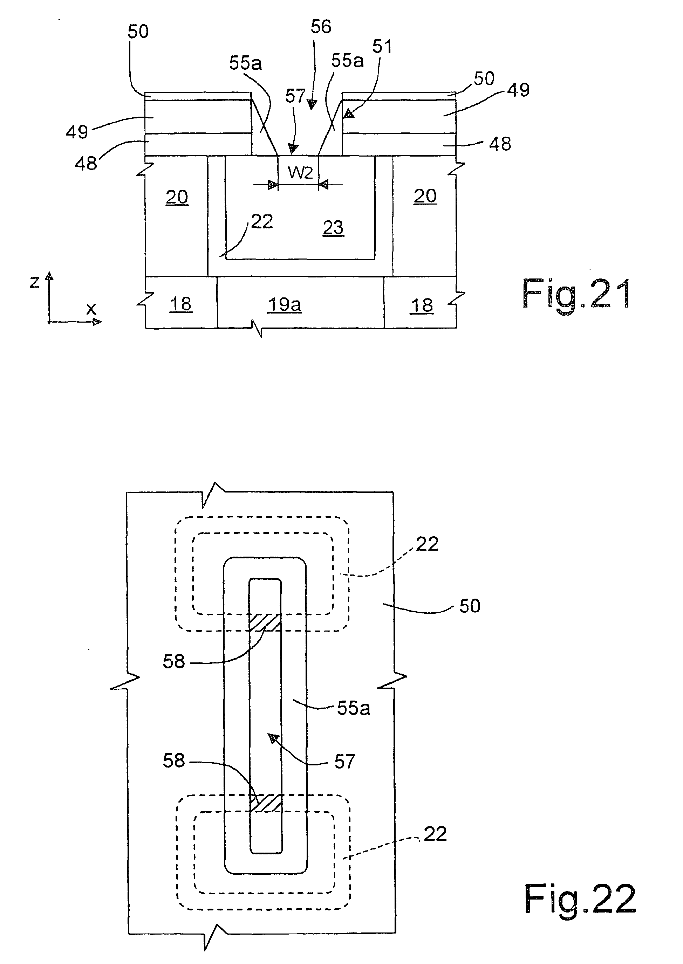

The process according to the present invention comprises initial steps equal to those described in patent application 01128461.9 illustrated above, up to deposition of the second dielectric layer 20 (Figure 7). Next, also here the openings 21 and the cup-shaped regions 22 are formed. However, as shown in Figure 17, for the definition of the openings 21, a heater mask D is used which has rectangular windows (the term "rectangular" also comprising the particular case of a square shape). Consequently, the openings 21 have a substantially rectangular shape. Then the heating layer, for example of TiSiN, TiAlN or TiSiC, with a thickness of 10-50 nm, preferably 20 nm, is deposited. The heating layer coats the walls and bottom of the openings 21 conformally. Consequently, in top plan view, the cup-like regions 22 here define an ideally rectangular shape, possibly with rounded edges (on account of the lithographic limits), or at the most an ovalized shape, with the longer side, or main direction, parallel to the X direction (Figure 22). Next, the heating layer is removed outside the openings 21 to form the cup-shaped regions 22, which are then filled with the dielectric material 23.

Then (Figure 18), a stop layer 48, for example of nitride deposited by PECVD (Plasma Enhanced Chemical Vapor Deposition) with a thickness of 40 nm, a mold layer 49, for example of USG deposited by PECVD or SACVD (Sub-Atmospheric Chemical Vapor Deposition) with a thickness of 50-70 nm, and an adhesion layer 50, for example of Ti or Si with a thickness of 20-40 nm, are deposited in sequence.

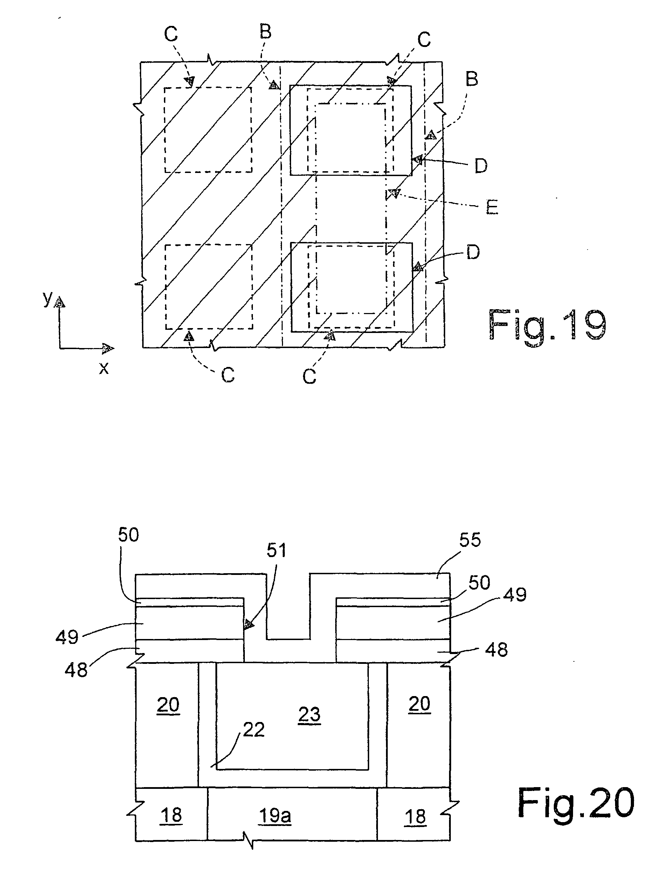

Next, using a minitrench mask, designated by E in Figure 19, the adhesion layer 50, the mold layer 49 and the stop layer 48 are etched. As shown in Figure 19, the minitrench mask E has a rectangular window that extends between two adjacent cells 5 in the Y direction (perpendicular to the alignment direction of the base and emitter regions 14, 15 of each memory cell 5, Figure 7).

Following upon etching, part of the layers 48, 49 and 50 is removed, so as to form an opening 51 having a rectangular shape, corresponding to that of the minitrench mask E. The width of the opening 51 in the X direction is, for example, 160 nm. The opening 51 uncovers part of the dielectric material 23 of the two adjacent cells 5 and crosses each cup-shaped region 22 only once, as can be clearly seen from the superposition of the heater mask D and minitrench mask E in Figure 19.

Next, Figure 20, a spacer layer 55, for example an oxide layer, is deposited (in particular, TEOS with a thickness of 50 nm). The spacer layer 55 covers the adhesion layer 50, as well as the walls and bottom of the opening 51.

Then, Figure 21, the spacer layer 55 is anisotropically etched back until the horizontal portions thereof are removed, according to the well known spacer formation technique. The spacer layer 55 is then completely removed above the adhesion layer 50 and is partially removed from the bottom of the opening 51 to form a spacer region 55a which extends along the vertical sides of the opening 51 (along the perimeter of a rectangle or of an oval) and delimits a slit 56, the base whereof forms a rectangular strip 57 having a sublithographic width W2 (in the X direction) of approximately 60 nm. Figure 22 is a top plan view of the structure thus obtained, and highlights how the strip 57 uncovers only one portion of the cup-shaped region 22 of each cell 5, shown with dashed line in the figure. The uncovered portion of each cup-shaped region 22 forms a contact area 58, as will be explained hereinafter.

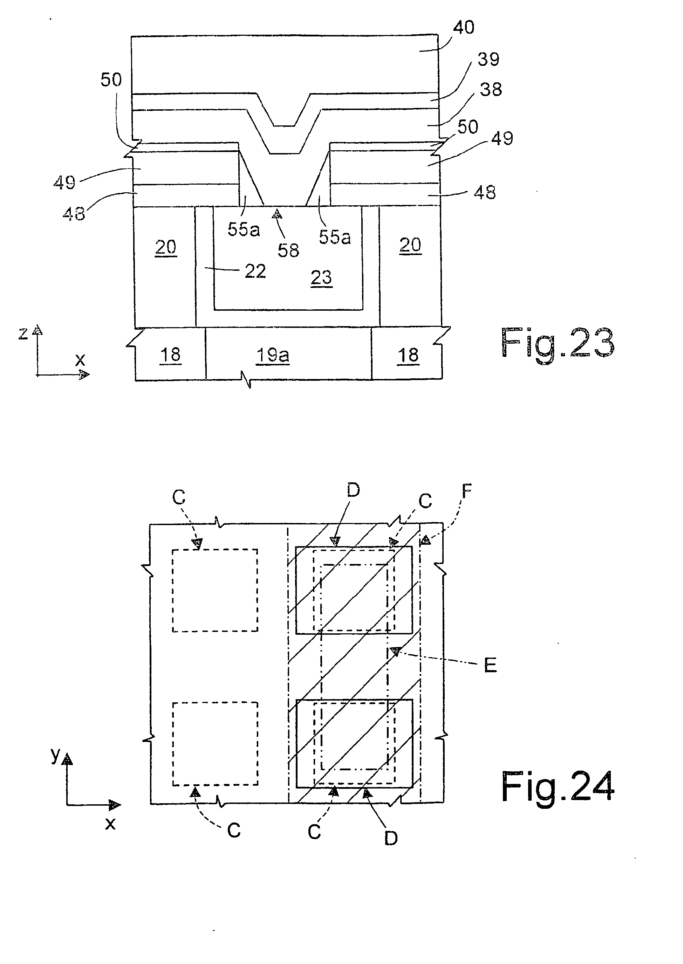

Next, Figure 23, the chalcogenic layer 38 (also in the present case, for instance, of Ge₂Sb₂Te₅ with a thickness of 60 nm), the barrier layer 39, and the metal layer 40 are deposited in succession, to form a stack of layers 41. The chalcogenic layer 38 is in direct contact with the adhesion layer 50, to which it adheres properly, and fills the slit 56 with a thin portion 38a. In particular, the thin portion 38a of the chalcogenic layer 38 deposits on the strip 57, contacting the cup-shaped regions 22 at the contact areas 58. The inclined wall formed by the spacer region 55a favors filling of the slit 56, so preventing problems linked to a poor aspect ratio of the opening 51.

Next, the stack of layers 41 is defined using a stack mask F (Figure 24).

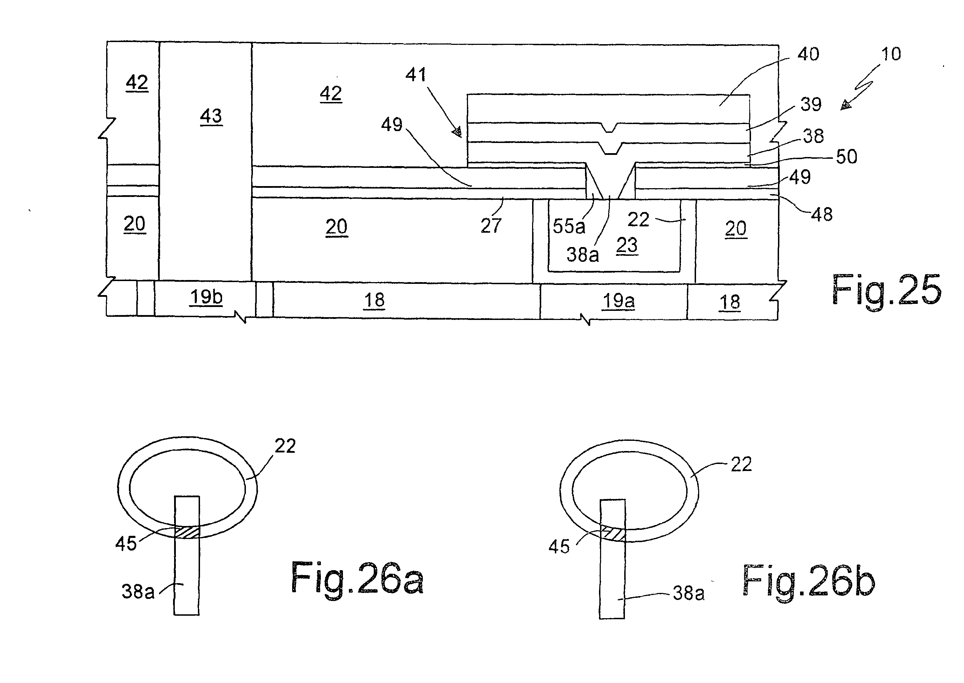

The process continues with the steps described previously, which comprise deposition of the third dielectric layer 42, opening of the third dielectric layer 42 above the base contacts 19b, formation of the top contacts 43, and formation of connection lines for connection to the base contacts 19b and to the bit lines 41, so as to obtain the final structure shown in Figure 25.

According to a different embodiment, the thin portion 38a of the chalcogenic layer 38 is formed using the technology described in the aforementioned patent application No. 01128461.9, and the second crossing-over between the cup-shaped region 22 and the thin portion 38a is avoided by using a special mask referred to as "rapier-selection mask", as described hereinafter.

In detail, the process comprises initial steps that are the same as those described with reference to Figures 4-9, with the sole difference that the cup-shaped region 22 is preferably formed using the mask of Figure 17 so as to obtain a rectangular shape or at the most an oval shape on account of the lithographic limits. At this point, the vertical wall 31a is present on the step 30 of the first delimitation layer 29, and the rest of the sacrificial layer 31 has already been removed.

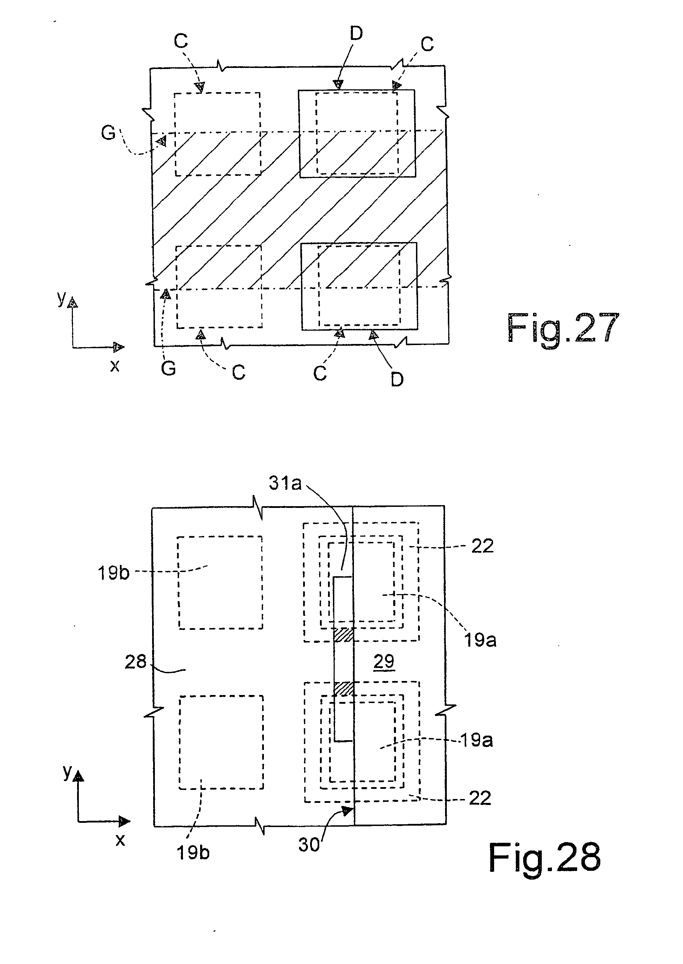

Next, using an appropriate mask referred to as "rapier-selection mask" G, illustrated in Figure 27, part of the vertical wall 31a is removed so that this wall intersects the cup-shaped region 22 of each shell 5 in just one point. In detail, the rapier-selection mask G covers a strip which extends parallel to the direction X bestriding two cells 5. The portions of the vertical wall 31a not covered by the rapier-selection mask G are then removed. In this way, as illustrated in the top plan view of Figure 28 regarding two adjacent cells 5, at the side of the step 30 there remains just one portion of vertical wall 31a, the section of which in the X-Z plane coincides with that of Figure 10 described above. As may be noted, the remaining portion of vertical wall 31a intersects each cup-shaped region 22 just once, as is highlighted by the hatched area which will subsequently come to form the contact area 45.

The process goes on with the same steps as those described above with reference to Figures 11-14, and then with deposition of the second delimitation layer 35; thinning of the delimitation layers 35 and 29, as well as of the vertical wall 31a until the structure of Figure 11 is obtained; removal of the sacrificial portion 36 and etching of the adhesion layers 28 and of the mold layer 27 (Figure 12); deposition of the chalcogenic layer 38 which fills the slit 37 of the mold layer 27; deposition of the barrier layer 39 and of the metal layer 40; shaping of the stack formed by the metal layer 40, the barrier layer 39, the chalcogenic layer 38 and the adhesion layer 28; deposition of the third dielectric layer 42; and the final steps described above for obtaining the structure illustrated in Figure 14.

In practice, in both of the embodiments thin portions 38a are formed having a roughly parallelepiped shape and short length, i.e., smaller than the overall dimensions of two cells 5 in the Y direction. In the first embodiment, the thin portion 38a is delimited by the spacer region 55a; in the second embodiment, the thin portion 38a is delimited directly by the mold layer 27.

The advantages of the process and structure described are illustrated hereinafter. First, it is possible to obtain just one contact area 45, 58 for each cup-shaped region 22, and thus for each cell 5; thereby the total contact area is reduced, so solving the problems highlighted above.

The elimination of the second contact can be obtained without requiring additional masking steps in the case where the thin region 38a is defined according to the first embodiment, using the minitrench technique thanks to the shape of the minitrench mask E.

With the second embodiment (i.e. using the rapier-selection mask G) the process allows instead smaller and more controllable dimensions by adding a special mask.

The rectangular or ovalized shape of the cup-shaped region 22 reduces the spread in the dimensions of the contact area 45, 58 also when its shape, instead of being rectangular as in the ideal case, is oval, as may be seen from a comparison between Figure 26a, which shows the position of the cup-shaped region 22 with respect to thin region 38a in the absence of mask misalignment, and Figure 26b, which shows the relative position in presence of misalignment.

Finally, it is clear that numerous modifications and variations may be made to the process and to the memory cell described and illustrated herein, all falling within the scope of the invention, as defined in the attached claims. For example, the sequence of steps required for forming the spacer region 55a and of the strip 57 may vary. In particular, for forming the opening 51 it is possible to etch the adhesion layer 50 and the mold layer 49 alone, without removing the stop layer 48. Next, the spacer region 55a is formed in the way described previously, by depositing a spacer layer and etching it anisotropically. Then, the stop layer 48 is removed only where it is not covered by the spacer region 55a, and in this way the strip 57 is uncovered. Before depositing the spacer layer 55, a nitride layer may be deposited and removed from the horizontal portions during the etch back so as to remain only under the spacer region 55a. This further nitride layer protects the adhesion layer 50 and prevents the latter to be contaminated by the spacer layer 55, of oxide, both upwardly and on the lateral sides. It also acts as an etch stop and avoid an undesired etching of the dielectric layer 20 and the dielectric material 23 during etch back when forming the spacer region 55a.

Furthermore, in the second embodiment, a stop layer may be deposed before the mold layer, analogously to what described for the first embodiment. Finally, when an adhesion layer is not required, the process according to the second embodiment may be simplified so as to form the delimitation layers 29, 35 directly on the insulating layer 20. In this case, the delimitation layers 29, 35 form themselves a mold layer and when the sacrificial region 31a is removed, the slit 37 is directly obtained.

## Claims

1. A contact structure in a semiconductor electronic device, comprising:
a first conductive region (22) and a second conductive region (38) of a phase change material which extends on top of said first conductive region (22),
said first conductive region (22) comprising a closed-shape wall including a first thin portion having a first sublithographic dimension in a first direction (Y);
said second conductive region (38) comprising a second thin portion (38a) having a second sublithographic dimension in a second direction (X) transverse to said first dimension, said second thin portion crossing, and being in direct electrical contact with, said first conductive region only at said first thin portion (22) so as to form a single contact area (45, 58) having a sublithographic extension.

2. A phase-change memory cell (5) comprising a resistive element (22) and a memory region (38) made of a phase-change material, which extends on top of said resistive element;
said resistive element comprising a wall having a closed shape including a first thin portion (22) having a first sublithographic dimension in a first direction (Y);
said memory region (38) comprising a second thin portion (38a) having a second sublithographic dimension in a second direction (X) transverse to said first dimension, said second thin portion (38a) crossing, and being in direct electrical contact with, said first resistive element only at said first thin portion (22) so as to form a single contact area (45, 58) having a sublithographic extension.

3. The memory cell according to claim 2, wherein said second thin portion (38a) is surrounded by a mold layer (27, 49) of a second dielectric material, which forms an opening (37; 51) having an approximately rectangular shape.

4. The memory cell according to claim 3, wherein said second thin portion (38a) is delimited on the side by, and is in direct contact with said mold layer (27), and said opening (37) has a sublithographic dimension.

5. The memory cell according to claim 3, wherein said second thin portion (38a) is surrounded by a spacer region (55a) housed in said opening (51), and said opening is of lithographic dimension.

6. The memory cell according to claim 5, wherein said resistive element (22) is formed inside an insulating layer (20), said mold layer (49) extends above said insulating layer, and a stop layer (48) extends between said insulating layer and said mold layer, said spacer region being of silicon dioxide, said mold layer (49) and said insulating layer (20) being of a silicon glass, and said stop layer (48) being of silicon nitride.

7. The memory cell according to any one of claims 2 to 6, wherein said closed line (22) is chosen between rectangular and elongated oval.

8. A memory array comprising at least two memory cells (5), each of which has a respective resistive element (22) having a closed-shape wall including a first thin portion having a first sublithographic dimension in a first direction (Y), said two memory cells further comprising a common memory region (38) of a phase change material extending above said resistive element (22) and including a second thin portion (38a) having a second sublithographic dimension in a second direction (X) transverse to said first dimension;
wherein said memory cells (5) are adjacent to one another in said first direction (Y);
each resistive element crossing, and being in direct electrical contact with, said second thin region (38a) only in a point of said first thin portion (22) so as to form a respective single contact area (58) having a sublithographic extension.

9. The memory array according to claim 8, wherein said second thin portion (38a) has an elongated shape and extends substantially along said first direction (Y) between said two memory cells (5).

10. A process for manufacturing a contact structure in a semiconductor electronic device, comprising:
forming a first conductive region (22) comprising a wall having a closed shape including a first thin portion having a first sublithographic dimension in a first direction (Y); and
forming a second conductive region (38) of a phase change material, said second conductive region including a second thin portion (38a) having a second sublithographic dimension extending in a second direction (X) transverse to said first dimension, said second thin portion crossing, and being in direct electrical contact with, said first conductive region (22) only at said first thin portion (22) so as to form a single contact area (45, 58) having a sublithographic extension.

11. A process for manufacturing a phase change memory cell, comprising:
forming a resistive element (22) comprising a closed-shape wall including a first thin portion having a first sublithographic dimension in a first direction (Y); and
forming a memory region (38) of a phase change material, the memory region including a second thin portion (38a) having a second sublithographic dimension extending in a second direction (X) transverse to said first dimension, said second thin portion crossing, and being in direct electrical contact with, said resistive element only at said first thin portion (22) so as to form a single contact area (45, 58) having a sublithographic extension.

12. The process according to claim 11, wherein said step of forming a memory region (38) comprises forming a mold structure (27; 49, 55a) on top of said resistive element (22), said mold structure having a slit (37, 56) crossing said first thin portion (22) only in a point, said slit having said second sublithographic dimension; depositing a phase change layer (38) at least inside said slit; and forming said second thin portion (38a).

13. The process according to claim 12, wherein said step of forming a mold structure (49, 55a) comprises depositing a mold layer (49); forming a first lithographic opening (51) in said mold layer; and forming spacer portions (55a) in said first lithographic opening, said spacer portions delimiting said slit (56).

14. The process according to claim 13, wherein said step of forming spacer portions (55a) comprises, after said step of forming a first lithographic opening (51), depositing a spacer layer (55) and anisotropically etching said spacer layer.

15. The process according to claim 13 or 14, wherein said spacer portions (55a) are of a first dielectric material and have surfaces inclined in a third direction transverse to said first and second directions, and said mold layer (49) is of a second dielectric material, wherein, prior to said step of forming a mold layer (49), a stop layer (48) of a third dielectric material is formed on top of said resistive element (22).

16. The process according to claim 12, wherein said resistive element (22) is formed in an insulating layer (20) and said step of forming a mold structure (27) comprises depositing a first delimitation layer (29) on top of said insulating layer, said first delimitation layer (29) forming a step having a vertical wall (30) extending transversely to said first thin portion (22); forming a sacrificial portion (31a) along said vertical wall; removing part of said sacrificial portion (31a) to form a sacrificial region (31a) that crosses said resistive element (22) in just one point; forming a second delimitation area (35) extending above said insulating layer (20) and at the sides of said sacrificial region (31a), as well as of said first delimitation layer (29); and removing said sacrificial region to form a delimitation opening.

17. The process according to claim 16, wherein, before forming a first delimitation layer (29), the step is carried out of depositing a mold layer (27) on top of said insulating layer (20); and in which, after said step of removing said sacrificial region (31a), the steps are carried out of forming said slit (37) in said mold layer (27) underneath said delimitation opening, and removing said first delimitation layer (29) and said second delimitation layer (35).

18. The process according to any one of claims 12 to 17, wherein said step of forming a resistive element (22) comprises forming a second lithographic opening (21) in an insulating layer (20), depositing a conductive layer (22) on a side wall of said second lithographic opening and filling (23) said second lithographic opening.

19. The process according to any one of claims 12 to 18, wherein said resistive element (22) is cup-shaped and comprises a vertical side which extends, in top plan view, along a closed line chosen between rectangular and elongated oval.

20. The process according to any one of claims 12 to 19, wherein said step of forming a mold structure (27; 49, 55a) comprises depositing a mold layer (27; 49), depositing an adhesion layer (50), and opening said mold layer and said adhesion layer.

21. A process for forming a pair of adjacent memory cells (5) in a first direction (Y), comprising the steps of:
forming a pair of resistive elements (22), each having a closed-shape wall and a first thin portion of a first sublithographic dimension in said first direction (Y),
forming a common memory region (38) of a phase change material including a second thin portion (38a) in direct electrical contact with said first thin portions and having a second sublithographic dimension in a second direction (X) transverse to said first dimension;
each resistive element forming, with said second thin region, a respective single contact area (45; 58) having a sublithographic extension.

22. The process according to claim 21, wherein said step of forming a common memory region (38) comprises forming a mold structure (27; 49, 55a) having a slit (37; 56) extending between said pair of resistive elements (22) and crossing each said first thin portion (22) of said resistive elements just in one point; said slit having said second sublithographic dimension; and depositing a phase change layer (38) at least inside said slit, and forming said second thin portion (38a).

23. The process according to claim 22, wherein said step of forming a mold structure comprises forming a mold layer (49) on top of said resistive element (22); forming a lithographic opening (51) in said mold layer; and forming spacer portions (55a) in said lithographic opening, said spacer portions delimiting said slit (56).

24. The process according to claim 23, wherein said resistive element is formed in an insulating layer (20) and said step of forming a mold structure (27) comprises depositing a mold layer (27) on top of said insulating layer; depositing a first delimitation layer (29) on top of said mold layer, said first delimitation layer (29) forming a step having a vertical wall (30) extending transversely with respect to said first thin portion (22) of said pair of cells; forming a sacrificial portion (31a) along said vertical wall; removing part of said sacrificial portion to form a sacrificial region (31a) which extends between said pair of cells (5) and crosses each said resistive element (22) only in a respective point; forming a second delimitation layer (35) on top of said insulating layer (20) and laterally to said sacrificial region and said first delimitation layer; removing said sacrificial region (31a) to form a delimitation opening; forming said slit (37) in said mold layer (27), underneath said delimitation opening; and removing said first and second delimitation layers.

25. The process according to claim 24, wherein said step of removing part of said sacrificial portion (31a) comprises depositing a mask (G) covering a region bestriding said pair of cells (5) and including said first thin portion (22) of said pair of cells.

## Patentansprüche

1. Kontaktstruktur in einer elektronischen Halbleitervorrichtung, die umfasst:
einen ersten leitenden Bereich (22) sowie einen zweiten leitenden Bereich (38) aus einem Phasenänderungsmaterial, der sich über dem ersten leitenden Bereich (22) erstreckt,
wobei der erste leitende Bereich (22) eine geschlossen geformte Wand umfasst, die einen ersten dünnen Abschnitt enthält, der eine erste sublithografische Abmessung in einer ersten Richtung (Y) hat;
wobei der zweite leitende Bereich (38) einen zweiten dünnen Abschnitt (38a) umfasst, der eine zweite lithografische Abmessung in einer zweiten Richtung (X) quer zu der ersten Abmessung hat und der zweite dünne Abschnitt den ersten leitenden Bereich nur an dem ersten dünnen Abschnitt (22) schneidet und in direktem elektrischem Kontakt mit ihm ist, so dass eine einzelne Kontaktzone (45, 58) entsteht, die eine sublithografischen Ausdehnung hat.

2. Phasenänderungs-Speicherzelle (5), die ein Widerstandselement (22) und einen Speicherbereich (38) umfasst, der aus einem Phasenänderungsmaterial besteht und sich über dem Widerstandselement erstreckt;
wobei das Widerstandselement eine Wand umfasst, die eine geschlossene Form hat, die einen ersten dünnen Bereich (22) enthält, der eine erste sublithografische Abmessung in einer ersten Richtung (Y) hat;
der Speicherbereich (38) einen zweiten dünnen Abschnitt (38a) umfasst, der eine zweite sublithografische Abmessung in einer zweiten Richtung (X) quer zu der ersten Abmessung hat, wobei der zweite dünne Abschnitt (38a) das erste Widerstandselement nur an dem ersten dünnen Abschnitt (22) schneidet und in direktem elektrischem Kontakt mit ihm ist, so dass eine einzelne Kontaktzone entsteht, die eine sublithografische Ausdehnung hat.

3. Speicherzelle nach Anspruch 2, wobei der zweite dünne Bereich (38a) von einer Formschicht (27, 49) aus einem zweiten dielektrischen Material umgeben wird, die eine Öffnung (37, 51) bildet, die eine annähernd rechteckige Form hat.

4. Speicherzelle nach Anspruch 3, wobei der zweite dünne Abschnitt (38a) an der Seite nur durch die Formschicht (27) begrenzt wird und in direktem Kontakt mit ihr ist und die Öffnung (37) eine sublithografische Abmessung hat.

5. Speicherzelle nach Anspruch 3, wobei der zweite dünne Abschnitt (38a) von einem Abstandshaltebereich (55a) umgeben wird, der in der Öffnung (51) aufgenommen ist, und die Öffnung lithografische Abmessung hat.

6. Speicherzelle nach Anspruch 5, wobei das Widerstandselement (22) innerhalb einer isolierenden Schicht (20) ausgebildet ist, sich die Formschicht (49) oberhalb der isolierenden Schicht erstreckt, sich eine Sperrschicht (48) zwischen der Isolierschicht und der Formschicht erstreckt, der Abstandshaltebereich aus Siliziumdioxid besteht, die Formschicht (49) sowie die Isolierschicht (20) aus Siliziumglas bestehen und die Sperrschicht (48) aus Siliziumnitrid besteht.

7. Speicherzelle nach einem der Ansprüche 2 bis 6, wobei die geschlossene Linie (22) zwischen rechteckig und länglich-oval ausgewählt wird.

8. Speicherfeld, das wenigstens zwei Speicherzellen (5) umfasst, von denen jede ein entsprechendes Widerstandselement (22) aufweist, das eine geschlossen geformte Wand hat, die einen ersten dünnen Abschnitt enthält, der eine erste sublithografische Abmessung in einer ersten Richtung (Y) hat, wobei die zwei Speicherzellen des Weiteren einen gemeinsamen Speicherbereich (38) aus einem Phasenänderungsmaterial umfassen, der sich oberhalb des Widerstandselementes (22) erstreckt und einen zweiten dünnen Abschnitt (38a) enthält, der eine zweite sublithografische Abmessung in einer zweiten Richtung (X) quer zu der ersten Abmessung hat;
wobei die Speicherzellen (5) in der ersten Richtung (Y) aneinandergrenzen;
jedes Widerstandselement den zweiten dünnen Bereich (38a) nur an einem Punkt des ersten dünnen Abschnitts (22) schneidet und in elektrischem Kontakt mit ihm ist, so dass eine jeweilige einzelne Kontaktzone (58) entsteht, die eine sublithografische Ausdehnung hat.

9. Speicherfeld nach Anspruch 8, wobei der zweite dünne Abschnitt (38a) eine längliche Form hat und sich im Wesentlichen entlang der ersten Richtung (Y) zwischen den zwei Speicherzellen (5) erstreckt.

10. Verfahren zum Herstellen einer Kontaktstruktur in einer elektronischen Halbleitervorrichtung, das umfasst:
Ausbilden eines ersten leitenden Bereiches (22), der eine Wand umfasst, die eine geschlossene Form hat, die einen ersten dünnen Bereich enthält, der eine erste sublithografische Abmessung in einer ersten Richtung (Y) hat; und
Ausbilden eines zweiten leitenden Bereiches (38) aus einem Phasenänderungsmaterial, wobei der zweite leitende Bereich einen zweiten dünnen Abschnitt (38a) enthält, der eine zweite sublithografische Abmessung hat, die sich in einer zweiten Richtung (X) quer zu der ersten Abmessung erstreckt, und der zweite dünne Abschnitt den ersten leitenden Bereich (22) nur an dem ersten dünnen Abschnitt (22) schneidet und in direktem elektrischem Kontakt mit ihm ist, so dass eine einzelne Kontaktzone (45, 58) entsteht, die eine sublithografische Ausdehnung hat.

11. Verfahren zum Herstellen einer Phasenänderungs-Speicherzelle, das umfasst:
Ausbilden eines Widerstandselementes (22), das eine geschlossen geformte Wand umfasst, die einen ersten dünnen Abschnitt enthält, der eine erste sublithografische Abmessung in einer ersten Richtung (Y) hat; und
Ausbilden eines Speicherbereiches (38) aus einem Phasenänderungsmaterial, wobei der Speicherbereich einen zweiten dünnen Abschnitt (38a) enthält, der eine zweite sublithografische Abmessung hat, die sich in einer zweiten Richtung (X) quer zu der ersten Abmessung erstreckt, und der zweite dünne Abschnitt das Widerstandselement nur an dem ersten dünnen Abschnitt (22) schneidet und in direktem elektrischem Kontakt mit ihm ist, so dass eine einzelne Kontaktzone (45, 58) entsteht, die eine sublithografische Ausdehnung hat.

12. Verfahren nach Anspruch 11, wobei der Schritt des Ausbildens eines Speicherbereiches (38) Ausbilden einer Formstruktur (27; 49, 55a) über dem Widerstandselement (22) umfasst, wobei die Formstruktur einen Schlitz (37, 56) hat, der den ersten dünnen Bereich (22) nur an einem Punkt schneidet, und der Schlitz die zweite sublithografische Abmessung hat, Abscheiden einer Phasenänderungsschicht (38) wenigstens im Inneren des Schlitzes und Ausbilden des zweiten dünnen Abschnitts (38a).

13. Verfahren nach Anspruch 12, wobei der Schritt des Ausbildens einer Formstruktur (39, 55a) Abscheiden einer Formschicht (49), Ausbilden einer ersten lithografischen Öffnung (51) in der Formschicht und Ausbilden von Abstandshalteabschnitten (55a) in der ersten lithografischen Öffnung umfasst und die Abstandshalteabschnitte den Schlitz (56) begrenzen.

14. Verfahren nach Anspruch 13, wobei der Schritt des Ausbildens der Abstandshalteabschnitte (55a) nach dem Schritt des Ausbildens der ersten lithografischen Öffnung (51) das Abscheiden einer Abstandshalteschicht (55) und anisotropes Ätzen der Abstandshalteschicht umfasst.

15. Verfahren nach Anspruch 13 oder 14, wobei die Abstandshalteabschnitte (55a) aus einem ersten dielektrischen Material bestehen und Flächen haben, die in einer dritten Richtung quer zu der ersten und der zweiten Richtung geneigt sind, die Formschicht (49) aus einem zweiten dielektrischen Material besteht, und vor dem Schritt des Ausbildens einer Formschicht (49) eine Sperrschicht (48) aus einem dritten dielektrischen Material über dem Widerstandselement (22) ausgebildet wird.

16. Verfahren nach Anspruch 12, wobei das Widerstandselement (22) in einer isolierenden Schicht (20) ausgebildet wird und der Schritt des Ausbildens der Formstruktur (27) Abscheiden einer ersten Begrenzungsschicht (29) über der isolierenden Schicht umfasst, wobei die erste Begrenzungsschicht (29) eine Stufe bildet, die eine vertikale Wand (30) hat, die sich quer zu dem ersten dünnen Abschnitt (22) erstreckt; Ausbilden eines Opferbereiches (31 a) entlang der vertikalen Wand; Entfernen eines Teils des Opferabschnitts (31 a), um einen Opferbereich (31 a) auszubilden, der das Widerstandselement (22) nur an einem Punkt schneidet, Ausbilden einer zweiten Begrenzungszone (35), die sich oberhalb der isolierenden Schicht (20) und an den Seiten des Opferbereiches (31 a) sowie der ersten Begrenzungsschicht (29) erstreckt, und Entfernen des Opferbereiches, um eine Begrenzungsöffnung auszubilden.

17. Verfahren nach Anspruch 16, wobei vor Ausbilden der ersten Begrenzungsschicht (29) der Schritt des Abscheidens einer Formschicht (27) über der isolierenden Schicht (20) ausgeführt wird und nach dem Schritt des Entfernens des Opferbereiches (31 a) die Schritte des Ausbildens des Schlitzes (37) in der Formschicht (27) unterhalb der Begrenzungsöffnung sowie des Entfernens der ersten Begrenzungsschicht (29) und der zweiten Begrenzungsschicht (35) ausgeführt werden.

18. Verfahren nach einem der Ansprüche 12 bis 17, wobei der Schritt des Ausbildens eines Widerstandselementes (22) Ausbilden einer zweiten lithografischen Öffnung (21) in einer isolierenden Schicht (20), Abscheiden einer leitenden Schicht (22) an einer Seitenwand der zweiten lithografischen Öffnung und Füllen (23) der zweiten lithografischen Öffnung umfasst.

19. Verfahren nach einem der Ansprüche 12 bis 18, wobei das Widerstandselement (22) becherförmig ist und eine vertikale Seite umfasst, die sich in Draufsicht gesehen, entlang einer geschlossenen Linie erstreckt, die zwischen rechteckig und länglich-oval ausgewählt wird.

20. Verfahren nach einem der Ansprüche 12 bis 19, wobei der Schritt des Ausbildens einer Formstruktur (27; 49, 55a) Abscheiden einer Formschicht (27; 49), Abscheiden einer Klebeschicht (50) und Öffnen der Formschicht sowie der Klebeschicht umfasst.

21. Verfahren zum Ausbilden eines Paars aneinandergrenzender Speicherzellen (5) in einer ersten Richtung (Y), das die folgenden Schritte umfasst:
Ausbilden eines Paars von Widerstandselementen (22), die jeweils eine geschlossen geformte Wand und einen ersten dünnen Abschnitt einer ersten lithografischen Abmessung in der ersten Richtung (Y) haben,
Ausbilden eines gemeinsamen Speicherbereiches (38) aus einem Phasenänderungsmaterial, der einen zweiten dünnen Abschnitt (38a) in direktem elektrischem Kontakt mit den ersten dünnen Abschnitten enthält und eine zweite sublithografische Abmessung in einer zweiten Richtung (X) quer zu ersten Richtung hat;
wobei jedes Widerstandselement mit dem zweiten dünnen Bereich eine jeweilige einzelne Kontaktzone (45; 58) bildet, die eine sublithografische Ausdehnung hat.

22. Verfahren nach Anspruch 22, wobei der Schritt des Ausbildens eines gemeinsamen Speicherbereiches (38) Ausbilden einer Formstruktur (27; 49, 55a) umfasst, die einen Schlitz (37; 56) hat, der sich zwischen dem Paar von Widerstandselementen (22) erstreckt und jeden der ersten dünnen Abschnitte (22) der Widerstandselemente nur an einem Punkt schneidet, wobei der Schlitz die zweite lithografische Abmessung hat; und Abscheiden einer Phasenänderungsschicht (38) wenigstens im Inneren des Schlitzes sowie Ausbilden des zweiten dünnen Abschnitts (38a).

23. Verfahren nach Anspruch 22, wobei der Schritt des Ausbildens einer Formstruktur Ausbilden einer Formstruktur (49) über dem Widerstandselement (22), Ausbilden einer lithografischen Öffnung (51) in der Formschicht und Ausbilden von Abstandshalteabschnitten (55a) in der lithografischen Öffnung umfasst, wobei die Abstandshalteabschnitte den Schlitz (56) begrenzen.

24. Verfahren nach Anspruch 23, wobei das Widerstandselement in einer isolierenden Schicht (20) ausgebildet wird und der Schritt des Ausbildens einer Formstruktur (27) Abscheiden einer Formschicht (27) über der isolierenden Schicht, und Abscheiden einer ersten Begrenzungsschicht (29) über der Formschicht umfasst, wobei die erste Begrenzungsschicht (29) eine Stufe bildet, die eine vertikale Wand (30) hat, die sich in Bezug auf den ersten dünnen Abschnitt (22) des Paars von Zellen quer erstreckt, Ausbilden eines Opferabschnitts (31 a) entlang der vertikalen Wand, Entfernen eines Teils des Opferabschnitts, um einen Opferbereich (31 a) auszubilden, der sich zwischen dem Paar von Zellen (45) erstreckt und jedes Widerstandselement (22) nur an einem entsprechenden Punkt schneidet, Ausbilden einer zweiten Begrenzungsschicht (35) über der isolierenden Schicht (20) und seitlich zu dem Opferbereich und der ersten Begrenzungsschicht, Entfernen des Opferbereiches (31 a), um eine Begrenzungsöffnung auszubilden, Ausbilden des Schlitzes (37) in der Formschicht (27) unterhalb der Begrenzungsöffnung sowie Entfernen der ersten und der zweiten Begrenzungsschicht.

25. Verfahren nach Anspruch 24, wobei der Schritt des Entfernens des Opferabschnitts (31 a) Abscheiden einer Maske (G) umfasst, die einen Bereich abdeckt, der das Paar von Zellen (5) überspannt und den ersten dünnen Abschnitt (22) des Paars von Zellen einschließt.

## Revendications

1. Structure de contact dans un dispositif électronique semiconducteur, comprenant :
une première région conductrice (22) et une seconde région conductrice (38) d'un matériau à changement de phase qui s'étend sur la partie supérieure de ladite première région conductrice (22),
ladite première région conductrice (22) comprenant une paroi de forme fermée comprenant une première partie mince ayant une première dimension sublithographique dans une première direction (Y) ;
ladite seconde région conductrice (38) comprenant une seconde partie mince (38a) ayant une seconde dimension sublithographique dans une seconde direction (X) transversale à ladite première dimension, ladite seconde partie mince traversant ladite première région conductrice, et étant en contact électrique direct avec celle-ci, uniquement au niveau de ladite première partie mince (22) de manière à former une zone de contact unique (45, 58) ayant une extension sublithographique.

2. Cellule mémoire à changement de phase (5) comprenant un élément résistant (22) et une région de mémoire (38) constituée d'un matériau à changement de phase, qui s'étend sur la partie supérieure dudit élément résistant ;
ledit élément résistant comprenant une paroi ayant une forme fermée comprenant une première partie mince (22) ayant une première dimension sublithographique dans une première direction (Y) ;
ladite région de mémoire (38) comprenant une seconde partie mince (38a) ayant une seconde dimension sublithographique dans une seconde direction (X) transversale à ladite première dimension, ladite seconde partie mince (38a) traversant ledit premier élément résistant, et étant en contact électrique direct avec celui-ci, uniquement au niveau de ladite première partie mince (22) de manière à former une zone de contact unique (45, 58) ayant une extension sublithographique.

3. Cellule mémoire selon la revendication 2, dans laquelle ladite seconde partie mince (38a) est entourée par une couche de moulage (27, 49) d'un second matériau diélectrique, qui forme une ouverture (37, 51) ayant une forme approximativement rectangulaire.

4. Cellule mémoire selon la revendication 3, dans laquelle ladite seconde partie mince (38a) est délimitée sur le côté par ladite couche de moulage (27) et est en contact direct avec celle-ci et ladite ouverture (37) a une dimension sublithographique.

5. Cellule mémoire selon la revendication 3, dans laquelle ladite seconde partie mince (38a) est entourée par une région d'espacement (55a) logée dans ladite ouverture (51) et ladite ouverture a une dimension lithographique.

6. Cellule mémoire selon la revendication 5, dans laquelle ledit élément résistant (22) est formé à l'intérieur d'une couche isolante (20), ladite couche de moulage (49) s'étend au-dessus de ladite couche isolante et une couche butoir (48) s'étend entre ladite couche isolante et ladite couche de moulage, ladite région d'espacement étant constituée de dioxyde de silicium, ladite couche de moulage (49) et ladite couche isolante (20) étant constituées d'un verre de silicium et ladite couche butoir (48) étant constituée de nitrure de silicium.

7. Cellule mémoire selon l'une quelconque des revendications 2 à 6, dans laquelle ladite ligne fermée (22) est choisie entre rectangulaire et ovale allongée.

8. Matrice mémoire comprenant au moins deux cellules mémoire (5), dont chacune comporte un élément résistant respectif (22) ayant une paroi de forme fermée comprenant une première partie mince ayant une première dimension sublithographique dans une première direction (Y), lesdites deux cellules mémoire comprenant en outre une région de mémoire commune (38) constitué d'un matériau à changement de phase s'étendant au-dessus dudit élément résistant (22) et comprenant une seconde partie mince (38a) ayant une seconde dimension sublithographique dans une seconde direction (X) transversale à ladite première dimension ;
dans laquelle lesdites cellules mémoire (5) sont adjacentes l'une à l'autre dans ladite première direction (Y) ;
chaque élément résistant traversant ladite seconde région mince (38a) et étant en contact électrique direct avec celle-ci uniquement au niveau d'un point de ladite première partie mince (22) de manière à former une zone de contact unique respective (58) comportant une extension sublithographique.

9. Matrice mémoire selon la revendication 8, dans laquelle ladite seconde partie mince (38a) a une forme allongée et s'étend sensiblement le long de ladite première direction (Y) entre lesdites deux cellules mémoire (5).

10. Procédé de fabrication d'une structure de contact dans un dispositif électronique semiconducteur, comprenant :
la formation d'une première région conductrice (22) comprenant une paroi de forme fermée comprenant une première partie mince ayant une première dimension sublithographique dans une première direction (Y) ; et la formation d'une seconde région conductrice (38) d'un matériau à changement de phase, ladite seconde région conductrice comprenant une seconde partie mince (38a) ayant une seconde dimension sublithographique s'étendant dans une seconde direction (X) transversale à ladite première dimension, ladite seconde partie mince traversant ladite première région conductrice (22), et étant en contact électrique direct avec celle-ci, uniquement au niveau de ladite première partie mince (22) de manière à former une zone de contact unique (45, 58) ayant une extension sublithographique.

11. Procédé de fabrication d'une cellule mémoire à changement de phase, comprenant :
la formation d'un élément résistant (22) comprenant une paroi de forme fermée comprenant une première partie mince ayant une première dimension sublithographique dans une première direction (Y) ; et
la formation d'une région de mémoire (38) constituée d'un matériau à changement de phase, la région de mémoire comprenant une seconde partie mince (38a) ayant une seconde dimension sublithographique s'étendant dans une seconde direction (X) transversale à ladite première dimension, ladite seconde partie mince traversant ledit élément résistant, et étant en contact électrique direct avec celui-ci, uniquement au niveau de ladite première partie mince (22) de manière à former une zone de contact unique (45, 58) ayant une extension sublithographique.

12. Procédé selon la revendication 11, dans lequel ladite étape de formation d'une région de mémoire (38) comprend la formation d'une structure de moulage (27, 49, 55a) sur la partie supérieure dudit élément résistant (22), ladite structure de moulage comportant une fente (37, 56) traversant ladite première partie mince (22) uniquement au niveau d'un point, ladite fente ayant ladite seconde dimension sublithographique ; le dépôt d'une couche à changement de phase (38) au moins à l'intérieur de ladite fente ; et la formation de ladite seconde partie mince (38a).

13. Procédé selon la revendication 12, dans lequel ladite étape de formation d'une structure de moulage (49, 55a) comprend le dépôt d'une couche de moulage (49) ; la formation d'une première ouverture lithographique (51) dans ladite couche de moulage ; et la formation de parties d'espacement (55a) dans ladite première ouverture lithographique, lesdites parties d'espacement délimitant ladite fente (56).

14. Procédé selon la revendication 13, dans lequel ladite étape de formation des parties d'espacement (55a) comprend, après ladite étape de formation d'une première ouverture lithographique (51), le dépôt d'une couche d'espacement (55) et l'attaque chimique anisotrope de ladite couche d'espacement.

15. Procédé selon la revendication 13 ou 14, dans lequel lesdites parties d'espacement (55a) sont constituées d'un premier matériau diélectrique et ont des surfaces inclinées dans une troisième direction transversale auxdites première et seconde directions, et ladite couche de moulage (49) est constituée d'un second matériau diélectrique, dans lequel, avant ladite étape de formation d'une couche de moulage (49), une couche butoir (48) constituée d'un troisième matériau diélectrique est formée sur la partie supérieure dudit élément résistant (22).

16. Procédé selon la revendication 12, dans lequel ledit élément résistant (22) est formé dans une couche isolante (20) et ladite étape de formation d'une structure de moulage (27) comprend le dépôt d'une première couche de délimitation (29) sur la partie supérieure de ladite couche isolante, ladite première couche de délimitation (29) formant une marche ayant une paroi verticale (30) s'étendant de manière transversale par rapport à ladite première partie mince (22) ; la formation d'une partie consommable (31a) le long de ladite paroi verticale; l'élimination d'une partie de ladite partie consommable (31a) pour former une région de consommation (31 a) qui traverse ledit élément résistant (22) juste au niveau d'un point ; la formation d'une seconde zone de délimitation (35) s'étendant au-dessus de ladite couche isolante (20) et sur les côtés de ladite région consommable (31a), ainsi que de ladite première couche de délimitation (29) ; et l'élimination de ladite région consommable pour former une ouverture de délimitation.

17. Procédé selon la revendication 16, dans lequel, avant de former une première couche de délimitation (29), l'étape de dépôt d'une couche de moulage (27) sur la partie supérieure de ladite couche isolante (20) est effectuée ; et dans lequel, après ladite étape d'élimination de ladite région consommable (31a), les étapes de formation de ladite fente (37) dans ladite couche de moulage (27) sous ladite ouverture de délimitation et d'élimination de ladite première couche de délimitation (29) et de ladite seconde couche de délimitation (35) sont effectuées.

18. Procédé selon l'une quelconque des revendications 12 à 17,
dans lequel ladite étape de formation d'un élément résistant (22) comprend la formation d'une seconde ouverture lithographique (21) dans une couche isolante (20), le dépôt d'une couche conductrice (22) sur une paroi latérale de ladite seconde ouverture lithographique et le remplissage (23) de ladite seconde ouverture lithographique.

19. Procédé selon l'une quelconque des revendications 12 à 18, dans lequel ledit élément résistant (22) a une forme de coupe et comprend un côté vertical qui s'étend, en vue de dessus, le long d'une ligne fermée choisie entre rectangulaire et ovale allongée.

20. Procédé selon l'une quelconque des revendications 12 à 19, dans lequel ladite étape de formation d'une structure de moulage (27, 49, 55a) comprend le dépôt d'une couche de moulage (27, 49), le dépôt d'une couche adhésive (50) et l'ouverture de ladite couche de moulage et de ladite couche adhésive.

21. Procédé de formation d'une paire de cellules mémoire adjacentes (5) dans une première direction (Y), comprenant les étapes consistant à :
former une paire d'élément résistants (22), chacun ayant une paroi de forme fermée et une première partie mince ayant une première dimension sublithographique dans ladite première direction (Y),
former une région de mémoire commune (38) constituée d'un matériau à changement de phase comprenant une seconde partie mince (38a) en contact électrique direct avec lesdites premières parties minces et ayant une seconde dimension sublithographique dans une seconde direction (X) transversale à ladite première dimension ;
chaque élément résistant formant, avec ladite seconde région mince, une zone de contact unique respective (45, 58) ayant une extension sublithographique.

22. Procédé selon la revendication 21, dans lequel ladite étape de formation d'une région de mémoire commune (38) comprend la formation d'une structure de moulage (27, 49, 55a) comportant une fente (37, 56) s'étendant entre ladite paire d'éléments résistants (22) et traversant chacune desdites premières parties minces (22) desdits éléments résistants juste au niveau d'un point ; ladite fente ayant ladite seconde dimension sublithographique ; et le dépôt d'une couche à changement de phase (38) au moins à l'intérieur de ladite fente et la formation de ladite seconde partie mince (38a).

23. Procédé selon la revendication 22, dans lequel ladite étape de formation d'une structure de moulage comprend la formation d'une couche de moulage (49) sur la partie supérieure dudit élément résistant (22) ; la formation d'une ouverture lithographique (51) dans ladite couche de moulage ; et la formation de parties d'espacement (55a) dans ladite ouverture lithographique, lesdites parties d'espacement délimitant ladite fente (56).

24. Procédé selon la revendication 23, dans lequel ledit élément résistant est formé dans une couche isolante (20) et ladite étape de formation d'une structure de moulage (27) comprend le dépôt d'une couche de moulage (27) sur la partie supérieure de ladite couche isolante ; le dépôt d'une première couche de délimitation (29) sur la partie supérieure de ladite couche de moulage, ladite première couche de délimitation (29) formant une marche ayant une paroi verticale (30) s'étendant de manière transversale par rapport à ladite première partie mince (22) de ladite paire de cellules ; la formation d'une partie consommable (31a) le long de ladite paroi verticale ; l'élimination d'une partie de ladite partie consommable pour former une région consommable (31a) qui s'étend entre ladite paire de cellules (5) et traverse chacun desdits éléments résistants (22) uniquement au niveau d'un point respectif; la formation d'une seconde couche de délimitation (35) sur la partie supérieure de ladite couche isolante (20) et de manière latérale à ladite région consommable et à ladite première couche de délimitation ; l'élimination de ladite région consommable (31a) pour former une ouverture de délimitation ; la formation de ladite fente (37) dans ladite couche de moulage (27), sous ladite ouverture de délimitation ; et l'élimination desdites première et seconde couches de délimitation.

25. Procédé selon la revendication 24, dans lequel ladite étape d'élimination d'une partie de ladite partie consommable (31a) comprend le dépôt d'un masque (G) couvrant une région enjambant ladite paire de cellules (5) et comprenant ladite première partie mince (22) de ladite paire de cellules.
